# EUROPÄISCHE PATENTANMELDUNG

(11) **EP 1 841 299 A2**
(43) Veröffentlichungstag der Anmeldung: **03.10.2007**
(21) Anmeldenummer: 07005337.6
(22) Anmeldetag: 15.03.2007
(51) Int. Cl.: H05K 1/14, H05K 3/36

(54) **Verbindungseinrichtung für elektronishche Bauelemente**

(30) Priorität: 01.04.2006 DE 102006015198
(71) Anmelder: SEMIKRON Elektronik GmbH & Co. KG, 90431 Nürnberg (DE)
(72) Erfinder: Göbel, Christian, 90441 Nürnberg (DE); Augustin, Karlheinz, 90768 Fürth (DE); Stockmeier, Thomas Dr., 91054 Erlangen (DE)

(57) **Zusammenfassung**

Die Erfindung beschreibt eine Verbindungseinrichtung zur elektrisch leitenden Verbindung von elektronischen Bauelementen und einem Substrat. Hierbei ist die Verbindungseinrichtung als ein Folienverbund aus mindestens einer isolierende Folie und zwei elektrisch leitenden Folien ausgebildet. Dieser Folienverbund ist als ein Schichtaufbau jeweils einer leitenden Folie mit einer isolierenden abwechselnd ausgebildet, wobei mindestens eine leitende Folie strukturiert ist und somit Leiterbahnen ausbildet. Weiterhin besteht mindestens eine leitende Folie einer Hauptfläche des Folienverbunds aus einem ersten Metall und weist mindestens einen Folienabschnitt mit einer im Vergleich zur Dicke dieser Folie dünneren Schicht eines zweiten Metalls auf.

## Beschreibung

Die Erfindung beschreibt eine Verbindungseinrichtung zur elektrisch leitenden Verbindung von elektronischen Bauelementen und mindestens einem Substrat, wobei die Verbindungseinrichtung als ein Folienverbund ausgebildet ist.

Es ist eine Vielzahl von Verbindungseinrichtungen für elektronische Bauelemente bekannt. Bei gehausten Bauelementen sind beispielhaft metallische Verbindungseinrichtung und deren löttechnische Verbindung mit Substraten bekannt, wobei hier unter Substraten auch jegliche Art von Leiterplatten verstanden werden soll.

Bei ungehausten Bauelementen ist als Verbindungseinrichtung die Drahtbondverbindung weit verbreitet. Im Bereich von Leistungshalbleitermodulen sind weiterhin formschlüssige Verbindungen, als sog. Druckkontaktierung bekannt. Ebenfalls von Leistungshalbleitermodulen sind druckkontaktierte flexible Leiterplatten als Verbindungseinrichtungen bekannt. Die DE 102 21 970 A1 offenbart ein Leistungshalbleitermodul mit einer derartigen Verbindungseinrichtung, lässt allerdings deren exakte Ausgestaltung offen.

Die DE 103 55 925 A1 offenbart eine Verbindungseinrichtung für Leistungshalbleiterbauelemente bestehend aus einem Folienverbund einer ersten und einer zweiten elektrisch leitenden Folie mit einer isolierenden Zwischenlage. Die Leistungshalbleiterbauelemente sind mit der ersten leitenden Schicht mittels Ultraschallschweißen dauerhaft sicher elektrisch verbunden. Die modulinterne schaltungsgerechte Verbindung der Leistungshalbleiterbauelemente mit Leiterbahnen eines Substrats ist hierbei mittels metallischer Kontaktelemente ausgebildet deren Dicke derjenigen der Leistungshalbleiterbauelemente angepassten ist. Diese Kontaktelemente werden ebenfalls wie die Leistungshalbleiterbauelemente mittels Ultraschallschweißen mit der Verbindungseinrichtung verbunden.

Die leitende Folie zur Ultraschallschweißverbindung mit Leistungshalbleiterbauelement und Kontaktelemente besteht hierbei aus Aluminium mit Prägenoppen, da Aluminium eine vorzügliche Schweißverbindung mit der ebenfalls aus einer letzten Lage Aluminium bestehenden Metallisierung des Leistungshalbleiterbauelements eingeht.

Nachteilig ist hierbei, dass Lötverbindungen mit dieser Aluminiumschicht nicht oder nur sehr eingeschränkt möglich sind. Eine Ausgestaltung der entsprechenden Schicht mittels Kupfer, welches eine höhere spezifische Leitfähigkeit aufweist sowie lötfahig ist, ist hier nicht offenbart, da diese Schicht für eine Schweißverbindung mit den Leistungshalbleiterbauelementen nicht geeignet ist.

Der Erfindung liegt die Aufgabe zugrunde eine Verbindungseinrichtung für elektronische Bauelemente, wie beispielhaft ungehauste Leistungshalbleiterbauelemente sowie gehauste oder ungehauste integrierte Schaltkreise, vorzustellen, die sowohl einer Schweiß- wie auch einer Lötverbindung zugänglich ist und eine Mehrzahl von Bauelementen in einfacher, schnell herstellbarer und flexibler Weise verbindet.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von den, ist aber nicht beschränkt auf die, Anforderungen eines intelligenten Leistungshalbleitermoduls mit einer Mehrzahl von verschieden anzuordnenden und schaltungsgerecht zu verbindenden Bauelementen. In einem derartigen Leistungshalbleitermodul sind ungehauste Leistungshalbleiterbauelement miteinander und / oder mit Leiterbahnen eines Substrats, auf dem sie angeordnet sind, zu verbinden. Weiterhin müssen Steuer- und Hilfsanschlüsse mit Treiberbausteinen und weiteren elektronischen Bauelementen, die entweder gehaust oder ungehaust in dem Leistungshalbleitermodul angeordnet sind verbunden werden. Weiterhin sind beispielhaft Sensoren zur Temperatur- und / oder Strommessung mit zugeordneten Auswerteeinheiten zu verbinden. Ebenso sind die externen Anschlüsse der Lastanschlüsse sowie aller notwendigen Steuer- und Hilfsanschlüsse der Leistungshalbleiterbauelemente, wie auch der Treiberbausteine, zu verbinden.

Die erfindungsgemäße Verbindungseinrichtung ist ausgestaltet als ein Folienverbund aus mindestens einer isolierende Folie und zwei elektrisch leitenden Folien. Dieser Folienverbund weist einen Schichtaufbau beginnend mit einer leitenden und dann abwechselnd jeweils einer isolierenden und einer leitenden Folie auf. Mindestens eine leitende Folie ist in sich strukturiert und bildet somit voneinander elektrisch isolierte Leiterbahnen aus.

Mindestens eine aus einem ersten metallischen Werkstoff bestehende leitende Folie, die auf einer Hauptfläche des Folienverbunds angeordnet ist, weist mindestens einen Folienabschnitt auf, wobei auf diesem eine Schicht eines zweiten metallischen Werkstoffs angeordnet ist. Erfindungsgemäß ist die Schichtdicke dieser Schicht aus dem zweiten metallische Werkstoff dünner im Vergleich zur Schichtdicke der Folie aus dem ersten metallischen Werkstoff.

Besonders bevorzugte Weiterbildungen dieser Verbindungseinrichtung sind in der jeweiligen Beschreibung der Ausführungsbeispiele genannt. Die erfinderische Lösung wird zudem an Hand der Ausführungsbeispiele der Fig. 1 bis 3 weiter erläutert.

Fig. 1 zeigt im Querschnitt eine erste erfindungsgemäße Verbindungseinrichtung in einer Anordnung mit einem Substrat und Bauelementen.

Fig. 2 zeigt eine zweite erfindungsgemäße Verbindungseinrichtung in Draufsicht auf die erste Hauptfläche.

Fig. 3 zeigt eine zweite erfindungsgemäße Verbindungseinrichtung in einer Anordnung mit einem ungehausten Bauelement in Draufsicht auf die zweite Hauptfläche.

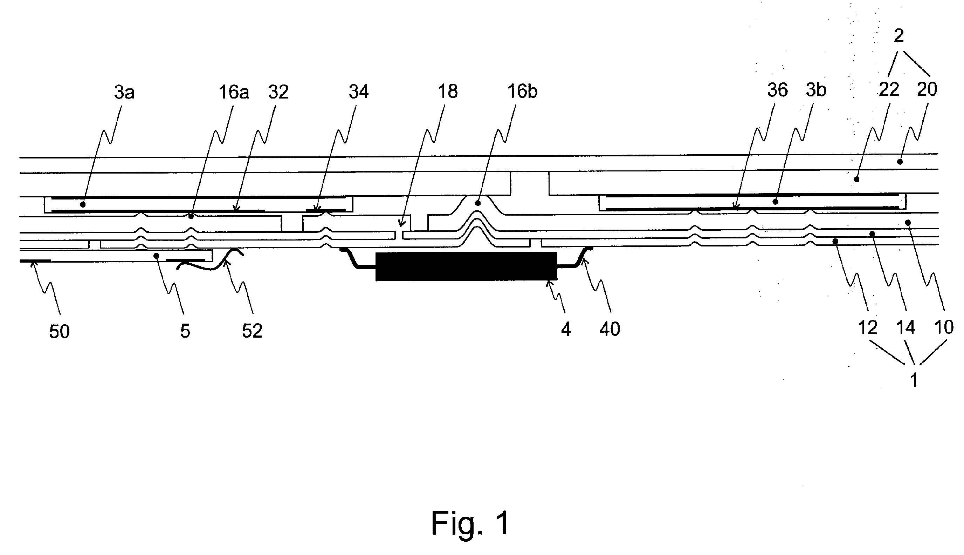

Fig. 1 zeigt eine erste erfindungsgemäße Verbindungseinrichtung (1) in der Anordnung mit einem Substrat (2) und Bauelementen (3 a/b, 4, 5) im Querschnitt. Das Substrat (2) weist auf seiner der Verbindungseinrichtung (1) zugewandten Seite elektrisch voneinander isolierte Leiterbahn (22) auf. Derartige Substrate (2) sind für die Verwendung in Leistungshalbleitermodulen vorzugsweise als sog. DCB (direct copper bonding) Substrate mit metallischen Leiterbahnen (22) aus Kupfer auf einem Keramikträger (20) ausgebildet. Ebenso geeignet sind beliebige andere Substrate, die elektrisch voneinander isolierte Leiterbahn ausbilden, wobei diese Leiterbahnen nicht, wie dargestellt, vollflächig unterhalb der auf.dem Substrat angeordneten Bauelemente ausgebildet sein muss. Diese Ausbildung ist allerdings bevorzugt, wenn Wärme aus dem Bauelement abgeführt werden muss.

Die auf den Leiterbahnen (22) des Substrats (2) angeordneten Bauelemente (3 a/b) sind hier eine Leistungsdiode (3b) und ein Leistungstransistor (3a), wobei dies keine Beschränkung auf diese Bauelemente bedeutet. Diese Leistungshalbleiterbauelemente (3 a/b) weisen auf ihrer der Verbindungseinrichtung (1) zugewandten Seite mindestens eine Kontaktfläche (32, 34, 36) auf. Im Fall der Leistungsdiode (3b) ist dies die Anode (36), im Fall des Leistungstransistors (3a) der Emitter (32), sowie die Basis (34). Gemäß dem Stand der Technik sind die Kontaktflächen der Leistungshalbleiterbauelemente (3 a/b) als eine Aluminiumschicht ausgebildet.

Die Verbindungseinrichtung (1) besteht in einer ersten Ausgestaltung aus einer ersten metallischen Folie (10), hier Aluminium mit einer Schichtdicke zwischen 50 und 400µm, einer hieran anschließenden Kunststofffolie (14) mit einer Schichtdicke zwischen 10 und 80µm und ein zweiten metallische Folie (12), hier Kupfer mit einer Schichtdicke zwischen 20 und 100µm, wobei die erste Folie mindestens die doppelte Dicke der zweiten aufweist.

Zur elektrisch leitenden Verbindung der ersten metallischen Folie (10) mit den Kontaktflächen (32, 34, 36) der Leistungshalbleiterbauelemente (3 a/b) weist der Folienverbund (1) erste Prägenoppen (16a) auf. Mittels eines Ultraschallschweißverfahrens werden diese Prägenoppen (16a) mit den zugeordneten Kontaktflächen (32, 34, 36) verbunden.

Zur elektrisch leitenden Verbindung der ersten metallischen Folie (10) mit Leiterbahnen (22) des Substrats (2) weist der Folienverbund (1) tiefer ausgebildete zweite Prägenoppen (16b) auf. Im Bereich dieser zweiten Prägenoppen (16b) ist auf der Aluminiumfolie (10) eine Schicht aus Kupfer mit einer bevorzugten Dicke zwischen 1 und 20µm abgeschieden. Hierbei ist es bevorzugt dies mittels eines galvanischen Verfahrens oder mittels Kaltgasspritzen durchzuführen. Die Kupferoberfläche dieser zweiten Prägenoppen (16b) ist löttechnisch mit der Kupferleiterbahn (22) des Substrats (2) verbunden.

Die Kunststofffolie (14) der Verbindungseinrichtung (1) weist Ausnehmungen für Durchkontaktierurigen (18) zwischen der ersten (10) und der zweiten (12) leitenden Schicht auf. Hierdurch werden. Potentiale der ersten auf die zweite Schicht gelegt. Dies ist beispielhaft für das Gatepotential des Leistungstransistors (3a) dargestellt.

Auf der zweiten metallischen Folie (12) sind hier beispielhaft zwei integrierte Schaltungen (4, 5) angeordnet. Es kann bevorzugt sein hier weitere Bauelementen wie einzelne Widerstände, Kondensatoren, Spulen oder auch Sensoren anzuordnen. Derartige Bauelemente können in weiteren Ausgestaltungen auch auf Leiterbahnen (22) des Substrats (2) angeordnet und schaltungsgerecht verbunden sein. Dargestellt ist eine erste integrierte Schaltung (4), hier als SMD Bauteil mit Kontakteinrichtungen (40) zur löttechnischen Verbindung zu zugeordneten Leiterbahn der zweiten Folie (12). Eine zweite integrierte Schaltung (5) ist hier als ungehaustes Bauelement dargestellt und klebetechnisch mit der zweiten leitenden Schicht (12) verbunden. Die elektrische Verbindung ist als Dünndrahtbondverbindung (52) einzelner Kontaktflächen (50) des Bauelements (5) mit zugeordneten Leiterbahnen der zweiten Schicht (12) ausgebildet.

Es kann bevorzugt sein auf den Abschnitten dieser Leiterbahnen, die mit den Bonddrähten (52) verbunden sind eine zweite metallische Schicht in der Ausgestaltung einer Goldschicht anzuordnen.

Externe Verbindung, beispielhaft Schraubverbindungen, dieser Verbindungseinrichtung (1) können als runde Ausnehmungen des gesamten Folienverbunds ausgebildet sein. Hierbei es bevorzugt auf mindestens einer leitenden Folienschicht einer Hauptfläche eine zweite metallische Schicht konzentrisch um diese Ausnehmungen anzuordnen. Hierbei ist es bevorzugt, wenn diese Schicht mindestens einer Dicke 100µm aufweist und mittels Kaltgasspritzen abgeschieden ist.

Die Verbindungseinrichtung (1) besteht in einer zweiten, nicht explizit dargestellten, Ausgestaltung aus einer ersten metallischen Folie, hier Kupfer mit einer Schichtdicke zwischen 30 und 300µm, einer hieran anschließenden Kunststofffolie mit eine Schichtdicke zwischen 10 und 80µm und ein zweiten metallische Folie, ebenfalls aus Kupfer mit einer Schichtdicke zwischen 30 und 300µm.

In dieser Ausgestaltung sind die Abschnitte der ersten Schicht, die der Schweißverbindung mit den Kontaktflächen der Leistungshalbleiterbauelemente dienen, mit einer zweiten Schicht aus Aluminium ausgebildet. Erst hierdurch ist es möglich eine dauerhaft haltbare Verbindung zur erreichen. Die Prägenoppen zur löttechnischen Verbindung mit den Leiterbahnen des Substrats benötigt hierbei keine zweite metallische Schicht.

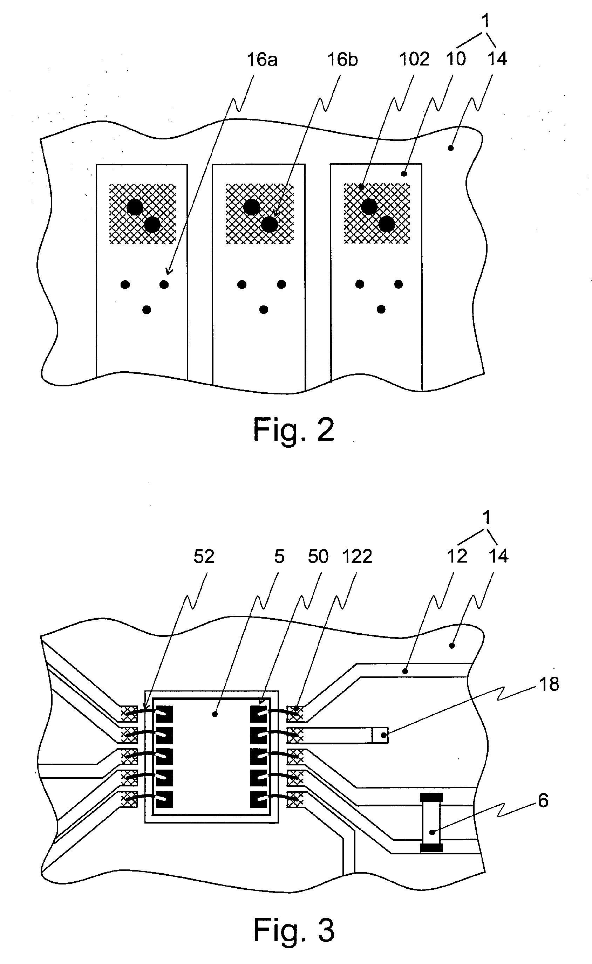

In den Fig. 2 und 3 wird ebenfalls der hier beschriebene dreischichtige Aufbau vorausgesetzt.

Weitere Ausgestaltungen der erfindungsgemäßen Verbindungseinrichtung weisen beispielhaft metallische Schichten aus jeweils gleichen Metallen mit gleicher Schichtdicke der beiden Schichten auf. Erfindungsgemäß kann es ebenso vorteilhaft sein eine Schichtfolge von 5 Schichten auszubilden, wobei hier die mittlere metallische Schicht vorzugsweise besonders dünn, als abschirmende Ebene ausgebildet ist und im Betrieb auf einem definierten Potential liegt.

Fig. 2 zeigt den Folienverbund einer zweiten erfindungsgemäßen Verbindungseinrichtung (1) in Draufsicht auf deren erste Hauptfläche. Dargestellt ist eine isolierende Schicht (14) in Ausgestaltung einer Kunststofffolie und in einer ersten Ausbildung des Folienverbunds eine erste leitende Schicht (10) aus Aluminium. Diese Aluminiumschicht (10) ist in sich strukturiert und bildet in diesem Ausschnitt des Folienverbunds drei Leiterbahnen aus, die voneinander elektrisch isoliert sind. Jede dieser Leiterbahn (10) weist zwei Gruppen von Prägenoppen (16 a/b) zu Ultraschallschweißverbindung von ungehausten Halbleiterbauelementen, hier von Leistungsdioden, bzw. zur Lötverbindung mit Leiterbahnen eines Substrats auf. Alternative Ausprägungen dieser Strukturierung sind geeignet für eine Vielzahl verschiedener zu verbindender ungehauster Bauelemente, nicht nur von Leistungshalbleiterbauelementen.

Die erste Gruppe von Prägenoppen (16a) ist in der ersten Ausgestaltung geeignet zur Punktschweißverbindung von Bauelementen mit vorzugsweise ebenfalls aus Aluminium gebildeten Kontaktflächen. Im Abschnitt der zweiten Gruppe von Prägenoppen (16b) ist die Aluminiumschicht mit einer dünneren Schicht (102) von galvanisch oder mittels Kaltgasspritzen abgeschiedenen Kupfers angeordnet. Diese Kupferschicht (102) ist besonders geeignet für eine Lötverbindung zu einer Leiterbahn des Substrats.

In einer zweiten, nicht dargestellten, Ausprägung besteht die zweite leitende Schicht aus Kupfer. Dies ist besonders bevorzugt, da Kupfer eine hohe Wärmeleitfähigkeit zum Abtransport von Verlustwärme der Bauelemente sowie einen geringen spezifischen Widerstand für eine hohe Stromtragfähigkeit aufweist. In diesem Fall muss die Gruppe von Prägenoppen zur Punktschweißverbindung zu Bauelementen mit einer zweiten Schicht aus Aluminium ausgebildet sein, um eine geeignete Oberfläche für die Schweißverbindung bereit zu stellen.

Fig. 3 zeigt eine zweite erfindungsgemäße Verbindungseinrichtung (1) in einer Anordnung mit einem hierauf angeordneten ungehausten Bauelement (1) in Draufsicht auf die zweite Hauptfläche. Dargestellt ist eine isolierende Schicht (14) in Ausgestaltung einer Kunststofffolie und eine zweite leitende Schicht (12) aus Kupfer. Diese Kupferschicht (12) ist im Vergleich zur ersten metallischen Schicht (10, vgl. Fig. 2) in sich feiner strukturiert und bildet in diesem Ausschnitt eine Fläche zur Klebeverbindung des Bauelements (5), hier eines Treiberschaltkreises zu Ansteuerung von Leistungshalbleiterbauelementen. Die Kupferschicht bildet weiterhin eine Vielzahl diesen Treiberschaltkreis verbindendende Leiterbahnen (12) aus. Diese Leiterbahnen sind wiederum voneinander elektrisch isoliert und weisen weitere Kontaktflächen für weitere Bauelemente, wie hier beispielhaft in Form eines Kondensators (6) gezeigt, auf. Diese Leiterbahnen weisen weiterhin Abschnitte auf, die mit einer weiteren metallischen Schicht (122) hier in Ausgestaltung einer Goldschicht mit einer Dicke zwischen 0,5 und 5µm auf versehen sind. Diese Abschnitte mit Goldbeschichtung sind die bevorzugten Kontaktflächen zur Dünndrahtbondverbindung (52) der Kontaktflächen (50) des Treiberschaltkreises (5) mit den Leiterbahnen (12). Ebenfalls dargestellt ist eine Durchkontaktierung (18) zur ersten leitenden Schicht des Folienverbunds.

## Patentansprüche

1. Verbindungseinrichtung (1) zur elektrisch leitenden Verbindung von elektronischen Bauelementen (3 a/b, 4, 5, 6) und mindestens einem Substrat (2), wobei die Verbindungseinrichtung (1) als ein Folienverbund aus mindestens einer isolierende Folie (14) und zwei elektrisch leitenden Folien (10, 12) ausgebildet ist, dieser Folienverbund in einem Schichtaufbau jeweils einer leitenden Folie mit einer isolierenden abwechselnd angeordnet ist und mindestens eine leitende Folie strukturiert ist und somit Leiterbahnen ausbildet, wobei mindestens eine leitende Folie (10, 12) einer Hauptfläche des Folienverbunds aus einem ersten Metall besteht und mindestens einen Folienabschnitt mit einer im Vergleich zur Dicke dieser Folie dünneren Schicht (102, 122) eines zweiten Metalls aufweist.

2. Verbindungseinrichtung nach Anspruch 1,
wobei mindestens eine isolierende Folie (14) mindestens eine Ausnehmung zur elektrisch leitenden Verbindung (18) benachbarter leitender Folien aufweist.

3. Verbindungseinrichtung nach Anspruch 1,
wobei der Folienverbund (1) mindestens eine Prägenoppe (16 a/b) aufweist.

4. Verbindungseinrichtung nach Anspruch 3,
wobei die Prägenoppe (16 a/b) in einem Folienabschnitt mit einer Schicht (102, 122) eines zweiten Metalls angeordnet ist.

5. Verbindungseinrichtung nach Anspruch 4 oder 5,
wobei ein ungehaustes Leistungshalbleiterbauelement (3 a/b) mittels einer Punktschweißverbindung mit Prägenoppen (16a) des Folienverbunds auf dessen ersten Hauptfläche angeordnet und schaltungsgerecht elektrisch leitend verbunden ist.

6. Verbindungseinrichtung nach Anspruch 4 oder 5,
wobei eine Leiterbahn (22) eines Substrats (2) mittels einer Lötverbindungen mit Prägenoppen (16b) des Folienverbunds (1) schaltungsgerecht elektrisch leitend verbunden ist.

7. Verbindungseinrichtung nach Anspruch 1,
wobei gehauste (4) oder ungehauste (5) Bauelemente auf der zweiten Hauptfläche des Folienverbunds (1) löttechnisch oder klebetechnisch angeordnet sind.

8. Verbindungseinrichtung nach Anspruch 7,
wobei ungehauste Bauelemente (5) mittels Dünndrahtbondverbindung (52) mit Leiterbahnen (12) der zweiten Hauptfläche des Folienverbunds (1) schaltungsgerecht elektrisch leitend verbunden sind.

9. Verbindungseinrichtung nach Anspruch 1,
wobei die Schicht (102, 122) aus dem zweitem Metall mittels Kaltgasspritzen abgeschieden ist.

10. Verbindungseinrichtung nach Anspruch 1,
wobei die Schicht (102, 122) aus dem zweitem Metall galvanisch abgeschieden ist.
